# EUROPÄISCHE PATENTSCHRIFT

(11) **EP 0 998 724 B1**
(45) Veröffentlichungstag und Bekanntmachung des Hinweises auf die Patenterteilung: **26.02.2003**
(21) Anmeldenummer: 98943710.8
(22) Anmeldetag: 21.07.1998
(51) Int. Cl.: G06K 19/077

(54) **VERFAHREN ZUR HERSTELLUNG EINES CHIPMODULS**
METHOD FOR PRODUCING A CHIP MODULE
PROCEDE DE PRODUCTION D'UN MODULE PUCE

(30) Priorität: 30.07.1997 DE 19732915
(43) Veröffentlichungstag der Anmeldung: 10.05.2000
(73) Patentinhaber: Infineon Technologies AG, 81669 München (DE)
(72) Erfinder: PÜSCHNER, Frank, D-93309 Kelheim (DE); FISCHER, Jürgen, D-93180 Deuerling (DE); HEINEMANN, Erik, D-93049 Regensburg (DE)
(74) Vertreter: Hermann, Uwe, Dipl.-Ing.
(86) Internationale Anmeldenummer: DE9802046
(87) Internationale Veröffentlichungsnummer: WO99006947

(56) Entgegenhaltungen:
- EP-A- 0 359 632
- DE-A- 4 336 501
- US-A- 5 122 860

## Beschreibung

Die Erfindung betrifft ein Verfahren zur Herstellung eines Chipmoduls, vorzugsweise für eine Chipkarte, gemäß dem Oberbegriff der Ansprüche 1 und 4.

Chipkarten sind in der Form von Kreditkarten, Telefonkarten etc. bekannt und weisen einen Chip mit einem integrierten Schaltkreis auf, mit dem Daten, Informationenen etc. gespeichert werden können. Die Chips werden üblicherweise vor ihrem Einbau in die Chipkarte zunächst auf einen Chipträger befestigt, und zwar auf einem Chipträgerbefestigungsabschnitt, der von Chipträgerkontaktabschnitten, welche großflächige Anschlußkontakte darstellen, mittels Schlitze getrennt ist. Nachdem die Anschlußdrähtchen des Chips mit den entsprechenden Chipträgerkontaktabschnitten elektrisch verbunden worden sind, wird der Chip mit den Anschlußdrähtchen auf dem Chipträger eingegossen. Die aus Chipträger, Chip und Vergußmasse (globe top) bestehende Einheit wird als Chipmodul bezeichnet.

Es ist bereits bekannt, bei der Chipmodulherstellung einen gestanzten Chipträger insbesondere aus einem Metallband (Leadframe) zu verwenden. Als Vergußmasse wird hierbei eine UV- oder thermisch härtende Abdeckmasse oder eine Moldmasse verwendet. Problematisch ist hierbei jedoch, daß beim Aufbringen der Vergußmasse diese durch die Schlitze des Chipträgers hindurchtritt und in unerwünschter Weise auf die Rückseite des Chipträgers gerät. Dieses Problem läßt sich zwar bekannterweise dadurch lösen, daß der Chipträger in eine Form eingesetzt wird, welche die Rückseite des Chipträgers abdichtet, jedoch ist dieses Herstellverfahren aufwändig und teuer. Weiterhin beträgt die Breite der durch Stanzen herstellbaren Schlitze normalerweise mindestens etwa 0,13 mm. Diese Breite ist jedoch noch zu groß, um ein Hindurchtreten einer dünnflüssigen Vergußmasse zuverlässig verhindern zu können.

In Dokument EP-A-359 632 wird dieses Problem gelöst, indem ein die Schlitze abeckendes, isolierendes Material gebraucht wird um das Durchfließen der vergussmasse zu verhindern.

Der Erfindung liegt daher die Aufgabe zugrunde, ein Verfahren der eingangs genannten Art zu schaffen, mit dem ein Chipmodul auf besonders einfache und kostengünstige Weise hergestellt werden kann.

Diese Aufgabe wird erfindungsgemäß durch die Merkmale der Ansprüche 1 und 4 gelöst. Vorteilhafte Ausführungsformen der Erfindung sind in den weiteren Ansprüchen beschrieben.

Bei dem erfindungsgemäßen Verfahren gemäß Anspruch 1 wird nach dem Stanzen des Chipträgers der Abstand zwischen dem Chipträgerbefestigungsabschnitt und den Chipträger-kontaktabschnitten durch einen zumindest im schlitznahen Bereich durchgeführten Prägevorgang auf ein das Durchfließen der Vergußmasse verhinderndes Maß verringert.

Durch den Prägevorgang (Press-/Stauchvorgang) kann eine Schlitzbreite erreicht werden, die zu gering ist, als daß Vergußmasse hindurchtreten könnte. Die Schlitze haben nach dem Prägevorgang eine Breite von beispielsweise 4 - 7 µm, d.h. eine Breite, wie sie durch den vorhergehenden Stanzvorgang nicht erreicht werden kann. Ein derartiger, durch einen Stanz- und Prägevorgang hergestellter Chipträger kann auf sehr kostengünstige Weise und mit sehr niedrigen Taktzeiten hergestellt werden, was die Kosten für die Fertigung des gesamten Chipmoduls bedeutend verringert. Weiterhin entsteht durch den Prägevorgang eine zusätzliche Vertiefung im Chipträger seitlich neben den Schlitzen, wodurch die Haftung der Vergußmasse auf dem Chipträger weiter verbessert wird.

Zweckmäßigerweise wird die Materialstärke des Chipträgers durch den Prägevorgang auf etwa 50% der ursprünglichen Materialstärke verringert.

Weiterhin wird die Aufgabe durch ein Verfahren gelöst, bei dem nach dem Stanzen des Chipträgers mittels eines Prägevorgangs eine Vertiefung in den an die Schlitze angrenzenden Bereich auf der dem Chip gegenüberliegenden Seite des Chipträgers eingebracht wird, wobei die Vertiefung einen Aufnahmeraum für durch die Schlitze hindurchtretende Vergußmasse bildet.

Auch hier wird der Chipträger wiederum durch eine Kombination aus einem Stanz- und Prägevorgang hergestellt, was eine bedeutende Kostenreduzierung und eine sehr schnelle Fertigung ermöglicht. In diesem Fall ist es jedoch unschädlich, wenn geringe Mengen Vergußmasse durch die Schlitze auf die Rückseite des Cipträgers gelangen, da die dort eingebrachten Vertiefungen einen Sammelraum für diese Vergußmasse bilden und daher die Gefahr verringern, daß die Vergußmasse über die Hauptebene der Rückseite vorsteht.

Die Erfindung wird nachfolgend anhand der Figuren beispielshaft näher erläutert. In diesen zeigen:
- Figur 1 :: einen schematischen Querschnitt durch einen Chip-modul zur Erläuterung einer ersten Ausführungsform des erfindungsgemäßen Verfahren, und
- Figur 2 :: einen schematischen Querschnitt durch einen Chip-modul zur Erläuterung einer zweiten Ausführungsform des erfindungsgemäßen Verfahrens.

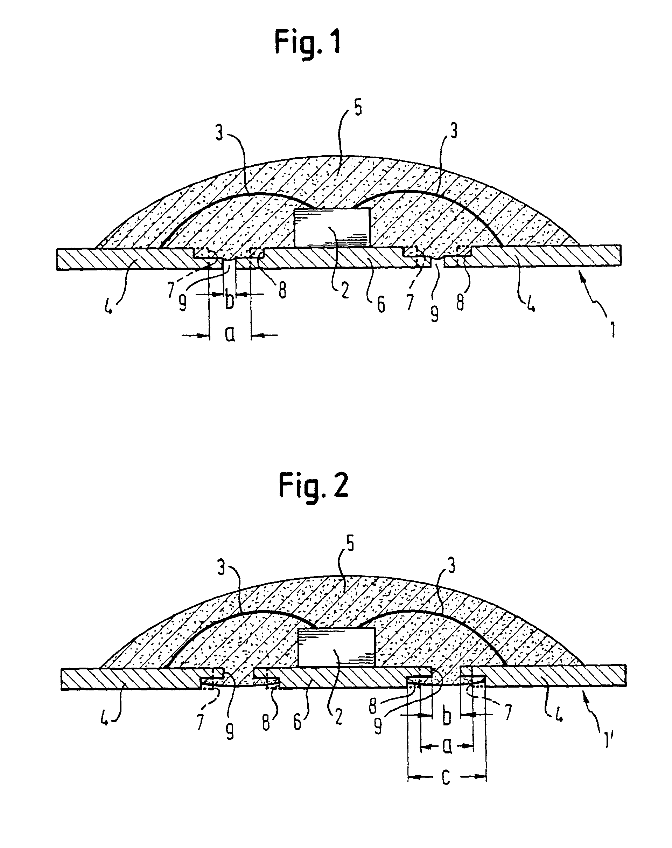

Der in Figur 1 gezeigte Chipmodul besteht im wesentlichen aus einem Chipträger 1, einem auf dem Chipträger 1 angeordneten Chip 2 mit Anschlußdrähtchen 3, die mit Chipträgerkontaktabschnitten 4 elektrisch verbunden sind, und einer Vergußmasse 5 (globe top), die auf die Oberseite des Chipträgers 1 aufgebracht wird und den Chip 2 sowie die Anschlußdrähtchen 3 vollständig bedeckt und auf dem Chipträger 1 fixiert.

Der Chipträger 1 besteht aus einem dünnen Metallband, das durch Stanzen in die Chipträgerkontaktabschnitte 4 und einen dazwischen mit Abstand angeordneten, den Chip 2 tragenden Chipträgerbefestigungsabschnitt 6 unterteilt wird. Unmittelbar nach dem Stanzvorgang weist der Chipträger 1 zwischen den Chipträgerkontaktabschnitten 4 und dem Chipträgerbefestigungsabschnitt 6 Schlitze 7 auf, die voneinander mit dem Abstand a beabstandet sind. In Figur 1 ist die Form des Chipträgers nach dem Stanzvorgang im Bereich der Schlitze 7 mit gepunkteten Linien eingezeichnet. Der Abstand a beträgt beispielsweise zwischen 0,15 und 0,20 mm und würde somit nicht verhindern können, daß eine entsprechend dünnflüssige Vergußmasse 5 durch die Schlitze 7 hindurch auf die Unterseite des Chipträgers 1 gelangt.

Um ein derartiges Hindurchtreten der (später aufgebrachten) Vergußmasse 5 zu verhindern, wird in einem nächsten Schritt von der Oberseite des Chipträgers 1 her ein Prägeschritt im Bereich der Schlitze 7 durchgeführt. Hierdurch wird im Bereich der Schlitze 7 eine Vertiefung 8 eingeprägt, welche bewirkt, daß die Schlitze 7 auf ein wesentlich kleineres Maß b von beispielsweise 0,05 mm zusammengedrückt werden. Diese verengten Schlitze sind in Figur 1 mit dem Bezugszeichen 9 versehen. Der Abstand zwischen dem Chipträgerbefestigungsabschnitt 6 und den Chipträgerkontaktabschnitten 4 ist nach dem Prägevorgang einerseits ausreichend groß, um die Chipträgerkontaktabschnitte 4 elektrisch vom Chipträgerbefestigungsabschnitt 6 zu isolieren, andererseits jedoch auch genügend klein, um ein Hindurchtreten der Vergußmasse 5 zuverlässig zu verhindern. Zweckmäßigerweise wird die Breite der Schlitze 9 auf die Viskosität der Vergußmasse 5 abgestimmt.

Nach dem Prägevorgang wird der Chip 2 in üblicher Weise auf dem Chipträgerbefestigungsabschnitt 6 befestigt, anschließend die Anschlußdrähtchen 3 zu den Chipträgerkontaktabschnitten 4 geführt und an diesen fixiert. Als letzten Schritt zur Chipmodulherstellung wird die Vergußmasse 5 über die gesamte Anordnung in der in Figur 1 gezeichneten Weise aufgebracht, so daß der Chip 2 und Anschlußdrähtchen 3 vollständig eingegossen und innerhalb der Vergußmasse 5 geschützt und fixiert sind.

Bei dem in Figur 2 dargestellten Ausführungsbeispiel eines alternativen Chipmoduls wird zunächst wiederum ein Chipträger 1' mittels eines Stanzvorgangs hergestellt, wobei Schlitze 7 zwischen dem Chipträgerbefestigungsabschnitt 6 und den Chipträgerkontaktabschnitten 4 mit der Breite a hergestellt werden (s. gepunktete Linien).

Im Gegensatz zu dem Ausführungsbeispiel von Figur 1 werden beim Ausführungsbeispiel von Figur 2 nicht von der Oberseite, sondern von der Rückseite des Chipträgers 1' her Vertiefungen 8 mittels eines Prägevorgangs im Bereich der Schlitze 7 eingebracht, welche die Breite c haben. Im gezeigten Ausführungsbeispiel beträgt die Tiefe der Vertiefungen 8 etwa 50 % der Dicke des Chipträgers 1'. Durch den Prägevorgang werden die Schlitze 7 wiederum auf das Maß b verengt, das in diesem Fall jedoch so groß sein kann, daß später aufgebrachte Vergußmassen 5 durch die verengten Schlitze 9 zur Rückseite des Chipträgers 1' hindurchtreten können. In diesem Fall wirken die Vertiefungen 8 als Aufnahmeraum für diesen hindurchtretenden Teil der Vergußmasse 5, wodurch die Gefahr bedeutend verringert wird, daß die Vergußmasse 5 über die Rückseite des Chipträgers 1' vorsteht.

Als Vergußmasse 5 wird zweckmäßigerweise eine schnellhärtende Abdeckmasse, beispielsweise eine UV oder thermisch härtende Abdeckmasse, verwendet.

Beide, in den Figuren 1 und 2 gezeigte Ausführungsformen bieten den Vorteil, daß durch die Kombination eines Stanz- und Prägeschritts der Chipträger 1, 1' auf sehr schnelle und kostengünstige Weise gefertigt werden kann.

## Patentansprüche

1. Verfahren zur Herstellung eines Chipmoduls, vorzugsweise für eine Chipkarte, bei dem ein elektronischer Chip (2) auf einen Chipträgerbefestigungsabschnitt (6) eines gestanzten Chipträgers (1) aus Metall angeordnet und Anschlußdrähtchen (3) des Chips (2) zu Chipträgerkontaktabschnitten (4) geführt werden, die zum Chipträgerbefestigungsabschnitt (6) mittels Schlitze (7) beabstandet angeordnet sind, worauf der Chip (2) mit den Anschlußdrähtchen (3) mittels einer Vergußmasse (5) auf dem Chipträger (1) eingekapselt wird, **dadurch gekennzeichnet, daß** nach dem Stanzen des Chipträgers (1) der Abstand zwischen dem Chipträgerbefestigungsabschnitt (6) und den Chipträgerkontaktabschnitten (4) durch einen zumindest im schlitznahen Bereich durchgeführten Prägevorgang auf ein das Durchfließen der Vergußmasse (5) verhinderndes Maß verringert wird.

2. Verfahren nach Anspruch 1, **dadurch gekennzeichnet, daß** die Materialstärke des Chipträgers (1) durch den Prägevorgang auf 30 bis 70 %, insbesondere 50 %, der ursprünglichen Materialstärke verringert wird.

3. Verfahren nach Anspruch 1 oder 2, **dadurch gekennzeichnet, daß** die Schlitze (7) durch den Prägevorgang auf eine Breite von 4 - 7 µm, insbesondere 5 µm verengt werden.

4. Verfahren zur Herstellung eines Chipmoduls, vorzugsweise für eine Chipkarte, bei dem ein elektronischer Chip (2) auf einem Chipträgerbefestigungsabschnitt (6) eines gestanzten Chipträgers 1' aus Metall angeordnet und Anschlußdrähtchen (3) des Chips (2) zu Chipträgerkontaktabschnitten (4) geführt werden, die zum Chipträgerbefestigungsabschnitt (6) mittels Schlitze (7) beabstandet angeordnet sind, worauf der Chip (2) mit den Anschlußdrähtchen (3) mittels einer Vergußmasse (5) auf dem Chipträger (1') eingekapselt wird, **dadurch gekennzeichnet, daß** nach dem Stanzen des Chipträgers (1') mittels eines Prägevorgangs eine Vertiefung (8) in den an die Schlitze (7) angrenzenden Bereich auf der dem Chip (2) gegenüberliegenden Seite des Chipträgers (1') eingebracht wird, wobei die Vertiefung (8) einen Aufnahmeraum für durch die Schlitze hindurchtretende Vergußmasse (5) bildet.

## Claims

1. Method for producing a chip module, preferably for a chip card, in which an electronic chip (2) is arranged on a chip carrier fixing section (6) of a punched chip carrier (1) made of metal and terminal wires (3) of the chip (2) are led to chip carrier contact sections (4), which are arranged spaced apart from the chip carrier fixing section (6) by means of slots (7), whereupon the chip (2) along with the terminal wires (3) is encapsulated on the chip carrier (1) by means of a sealing mass (5), **characterized in that**, after the punching of the chip carrier (1), the distance between the chip carrier fixing section (6) and the chip carrier contact sections (4) is reduced to a dimension preventing the flowing through of the sealing mass (5) by a swaging operation carried out at least in the region close to the slots.

2. Method as claimed in Claim 1, **characterized in that** the material thickness of the chip carrier (1) is reduced by the swaging operation to 30 to 70%, in particular 50%, of the original material thickness.

3. Method as claimed in Claim 1 or 2, **characterized in that** the slots (7) are constricted by the swaging operation to a width of 4 - 7 µm, in particular 5 µm.

4. Method for producing a chip module, preferably for a chip card, in which an electronic chip (2) is arranged on a chip carrier fixing section (6) of a punched chip carrier (1') made of metal and terminal wires (3) of the chip (2) are led to chip carrier contact sections (4), which are arranged spaced apart from the chip carrier fixing section (6) by means of slots (7), whereupon the chip (2), along with the terminal wires (3), is encapsulated on the chip carrier (1') by means of a sealing mass (5), **characterized in that**, after the punching of the chip carrier (1'), a depression (8) is made by means of a swaging operation into the region adjacent to the slots (7) on the side of the chip carrier (1') opposite from the chip (2), the depression (8) forming a receiving space for sealing mass (5) passing through the slots.

## Revendications

1. Procédé de production d'un module de puce, de préférence pour une carte à puce, dans lequel on met une puce (2) électronique sur un tronçon (6) de fixation d'un support (1) de puce estampé en métal et on fait passer des petits fils (3) de connexion de la puce (2) aux tronçons (4) de contact du support de puce qui sont disposés à distance du tronçon (6) de fixation du support de puce au moyen de fentes (7), la puce (2) étant encapsulée avec les petits fils (3) de connexion sur le support (1) de puce au moyen d'une composition de scellement, **caractérisé en ce qu'**après l'estampage du support (1) de puce, on diminue la distance entre le tronçon (6) de fixation du support de puce et les tronçons (4) de contact du support de puce par une opération d'impression effectuée au moins dans la zone proche de la fente dans une mesure empêchant l'écoulement de la composition (5) de scellement.

2. Procédé suivant la revendication 1, **caractérisé en ce que** l'on diminue l'épaisseur du matériau du support (1) de puce par l'opération d'impression jusqu'à 30 à 70 %, notamment jusqu'à 50 % de l'épaisseur initiale du matériau.

3. Procédé suivant la revendication 1 ou 2, **caractérisé en ce que** l'on ramène les fentes par l'opération d'impression à une largeur de 4 à 7 µm et notamment de 5 µm.

4. Procédé de production d'un module de puce, de préférence pour une carte à puce, dans lequel on met une puce (2) électronique sur un tronçon (6) de fixation d'un support (1') de puce estampé en métal et on fait passer des petits fils (3) de connexion de la puce (2) aux tronçons (4) de contact du support de puce qui sont disposés à distance du tronçon (6) de fixation du support de puce au moyen de fentes (7), la puce (2) étant encapsulée avec les petits fils (3) de connexion sur le support (1') de puce au moyen d'une composition de scellement, **caractérisé en ce qu'**après l'estampage du support (1') de puce, on ménage au moyen d'une opération d'impression une cavité (8) dans la zone adjacente à la fente (7) du côté du support (1') de puce qui est opposé à la puce (2) la cavité (8) formant une chambre de réception pour la composition (5) de scellement passant par la fente.
